# EUROPÄISCHE PATENTSCHRIFT

(11) **EP 2 321 845 B1**
(45) Veröffentlichungstag und Bekanntmachung des Hinweises auf die Patenterteilung: **04.07.2012**
(21) Anmeldenummer: 09777345.1
(22) Anmeldetag: 21.07.2009
(51) Int. Cl.: H01L 21/677, H01L 21/687

(54) **VORRICHTUNG UND VERFAHREN ZUM HANDHABEN VON SUBSTRATEN**
DEVICE AND METHOD FOR HANDLING SUBSTRATES
PROCEDE ET DISPOSITIF DE MANIPULATION DE SUBSTRATS

(30) Priorität: 01.09.2008 DE 102008045257
(43) Veröffentlichungstag der Anmeldung: 18.05.2011
(73) Patentinhaber: RENA GmbH, 78148 Gütenbach (DE)
(72) Erfinder: REUSTLE, Peter, 74399 Walheim (DE); GUTEKUNST, Mathias, 72221 Haiterbach (DE)
(74) Vertreter: Stürken, Joachim
(86) Internationale Anmeldenummer: PCT/EP2009/005297
(87) Internationale Veröffentlichungsnummer: WO 2010/022823

(56) Entgegenhaltungen:
- DE-A1- 4 232 902
- JP-A- 1 065 446
- JP-A- 59 182 046
- JP-A- 63 093 468
- JP-A- 2006 237 407
- JP-A- 2009 099 845
- US-A1- 2006 157 998
- US-A1- 2006 284 434
- "PROGRAMMABLE THREE-FINGER GRIPPER" IBM TECHNICAL DISCLOSURE BULLETIN, IBM CORP. NEW YORK, US, Bd. 33, Nr. 12, 1. Mai 1991 (1991-05-01), Seite 59/60, XP000121459 ISSN: 0018-8689

## Beschreibung

Die Erfindung betrifft das Handhaben von Substraten, z. B. als Wafer oder Solarzellen während der Herstellung derselben und/oder bei der späteren Verarbeitung dieser Güter. Diese bestehen z. B. aus dünnen Siliziumscheiben. Von daher sind sie sehr bruchempfindlich. Deshalb müssen sie beim Aufnehmen bzw. Ergreifen und Ablegen, oder allgemein beim Handhaben sehr stressfrei, d. h. ohne wesentliche Krafteinwirkung behandelt werden. Hinzu kommt, dass die bekannten Anlagen oder Prozesskammern zur Behandlung dieser Güter in der Regel ein sehr präzises Positionieren der Substrate an den Ablagestellen erfordern.

Die Druckschrift US2006/284434 A1 beschreibt eine Transportvorrichtung für substrate bei der Herstellung von Flüssigkristallanzeigen.

Die Druckschrift DE 202 12 107 U1 beschreibt einen Greifer für Bauteile, deren Lage beim Aufnehmen zunächst undefiniert ist. Nach dem Ergreifen des Gutes wird mittels mindestens einer Kamera, die an der Greifvorrichtung installiert ist, die Lage des Gutes am Greifer bestimmt und zwar während der Bewegung zur nächsten Position, d. h. zur Zielposition. Eine Steuereinrichtung wertet die Daten der Kamera aus, wodurch das präzise Ablegen des Gutes am Zielort mittels der Anlagensteuerung möglich ist. Zum Ergreifen des Gutes werden die bekannten Vakuumgreifer, Saugvorrichtungen und vorzugsweise Bernoulli-Greifer beschrieben. Diese haben jedoch den Nachteil, dass beim Aufnehmen und dem vertikalen Ablegen des Gutes ein unkontrollierbares horizontales Verschieben desselben erfolgen kann. Außerdem besteht bei derartigen Greifern die Gefahr des seitlichen Wegschwimmens des gegriffenen Gutes. Diesen Nachteil soll ein Greifer vermeiden, der in der Druckschrift DE 20 2007 007 721 U1 beschrieben ist. Das gegriffene Gut liegt an einer Dämpfungseinrichtung an. Der ansaugbedingte ungebremste Anschlag des Gutes an der Greiffläche des Greifers wird gemäß dieser Erfindung durch die umlaufende Dämpfungseinrichtung verringert. Das Gut landet stoßschonend an einer gummierten Anlagefläche, wodurch ein seitliches Wegschwimmen oder Verschieben auszuschließen ist. Ein kapazitiver Sensor erkennt das angesagte Gut. Eine möglicherweise erforderliche Korrektur der Position des Gutes beim Aufnehmen oder beim Ablegen ist bei dieser Erfindung nicht vorgesehen.

Aufgabe der Erfindung ist es, eine Greifvorrichtung zu beschreiben, insbesondere für bruchempfindliche Güter wie siliziumbasierte Wafer oder Solarzellen, die von einer Abholposition ungenau abgelegtes Gut stressfrei aufnehmen oder ergreifen und in einer Zielposition exakt positioniert und unversehrt ablegen kann.

Gelöst wird die Aufgabe durch die Vorrichtung gemäß Patentanspruch 1 und durch das Verfahren gemäß Patentanspruch 7. Die Unteransprüche beschreiben vorteilhafte Ausführungen der Erfindung.

Die Erfindung besteht aus mindestens einer Greifvorrichtung, die z. B. an einem Handhabungsgerät oder einem Roboterarm einer Produktionsanlage befestigt ist. Die jeweilige dreidimensionale Position des Handhabungsgerätes oder des Roboterarmes einschließlich ihrer Ausrichtung ist im Steuerungssystem der Produktionsanlage zur Nass- oder Trockenbehandlung des Gutes bekannt. Damit ist auch die exakte Position und Lage der Greifvorrichtung bekannt. In der Regel sind auch die Positionen bzw. Koordinaten der Ablagestellen der gesamten Anlage im Steuerungssystem bekannt, an denen von der Greifvorrichtung Güter aufzunehmen bzw. abzulegen sind. Nicht genau bekannt ist jedoch die Lage der Güter auf den Ablagestellen der jeweiligen Anlagenposition. Das Gut kann sich z. B. während einer Trockenbehandlung oder Nassbehandlung unbemerkt verschieben. Insbesondere wenn das Gut ein geringes Gewicht aufweist, wie z. B. eine Solarzelle, dann muss mit einer horizontalen Verschiebung während der Behandlung gerechnet werden. Für den nachfolgenden Prozess kann diese Verschiebung schon im Bereich von weniger als einem Millimeter unzulässig groß sein. Sie wird daher durch die erfindungsgemäße Greifvorrichtung für den oder die nachfolgenden Prozesse korrigiert. Hierzu dienen statische Richtanschläge und/oder bewegliche Richtmittel, die an der Greifvorrichtung angeordnet sind. Die Richtanschläge und die Richtmittel haben einen festen räumlichen Bezug zur Greifvorrichtung und damit zum Handhabungsgerät oder zum Roboterarm. Desgleichen auch Anschläge, die zur Begrenzung des Weges der Richtmittel verwendet werden können.

Das Ausrichten bzw. Richten des Gutes, d. h. die Wiederherstellung einer vorbestimmten Lage, kann an verschiedenen Orten erfolgen. So kann das Gut beim Abholen von einer Position bereits vor dem Aufnehmen bzw. Ergreifen gerichtet werden. Das Richten des Gutes kann auch nach dem Aufnehmen durch die Greifvorrichtung erfolgen. Hierzu befindet sich das Gut verschiebbar auf oder an mindestens einem Greifmittel als Träger oder als Vakuumgreifer, vorzugsweise als Bernoulli-Greifer. Dieses Richten kann z. B. zur Einsparung von Zeit während der Transportbewegung der Greifvorrichtung von einer Position zur nächsten erfolgen. Schließlich ermöglicht die Erfindung auch das Richten des Gutes nach dem Ablegen auf der Zielposition.

Die oder das Richtmittel werden oder wird mindestens von einem Richtaktor, der sich an oder in der Greifvorrichtung befindet, betätigt bzw. verlagert. Die Verlagerung erfolgt öffnend und schließend. Im geöffneten Zustand wird die Greifvorrichtung über dem in ungenauer bzw. unbestimmter Lage befindlichen Gut positioniert. Durch das Schließen der Richtmittel erfolgt die Wiederherstellung der bekannten Lage des Gutes in Bezug zur Greifvorrichtung. Das Schließen erfolgt vorteilhaft gegen Anschläge, die sich an der Greifvorrichtung ebenfalls in einer bekannten Lage für ein Gut mit einem bestimmten Nennmaß befinden. Durch diese Anschläge wird neben der korrekten Lage des Gutes auch erreicht, dass dieses durch ein ansonsten mögliches Einklemmen des Gutes durch die Richtmittel nicht beschädigt wird.

Die Richtmittel können auch auf einer anderen Bahn, z. B. linear oder nichtlinear verlagert werden, wobei das Gut in Zusammenwirken mit den Anschlägen ebenfalls in eine bekannte Lage geschoben wird, die in einem festen räumlichen Bezug zur Greifvorrichtung steht. Die Bewegungen bzw. Verlagerungen der Richtmittel können z. B. bei einem quadratischen Gut auch auf einer Kreisbahn erfolgen, mit dem Zentrum, das mit dem Zentrum des gerichteten Gutes übereinstimmt.

Die Erfindung wird nachfolgend an Hand der schematischen und nicht maßstäblichen Figuren 1 bis 5 detailliert beschrieben.

Die Figuren 1a bis 1f zeigen in der Seitenansicht eine Greifvorrichtung, die in der Anlagenposition n ein Gut aufnimmt und dieses in der Position n + x ablegt.

Die Figur 2a zeigt in der Draufsicht Richtmittel im geöffneten Zustand einschließlich der Aktoren als Beispiel für ein rundes Gut. Die Figur 2b zeig in der Draufsicht Richtmittel im geschlossenen Zustand einschließlich der Aktoren als Beispiel für ein rundes Gut.

Die Figur 3a zeigt in der Draufsicht Richtmittel im geöffneten Zustand einschließlich der Aktoren als Beispiel für ein quadratisches Gut. Die Figur 3b zeigt in der Draufsicht Richtmittel im geschlossenen Zustand einschließlich der Aktoren als Beispiel für ein quadratisches Gut.

Die Figuren 4a bis 4d zeigen Beispiele für das Richten des Gutes mit nur einem beweglichen Richtmittel und zwei statischen Richtanschlägen.

Die Figuren 5a bis 5g zeigen Beispiele für mögliche Querschnitte der Richtmittel oder der Richtanschläge.

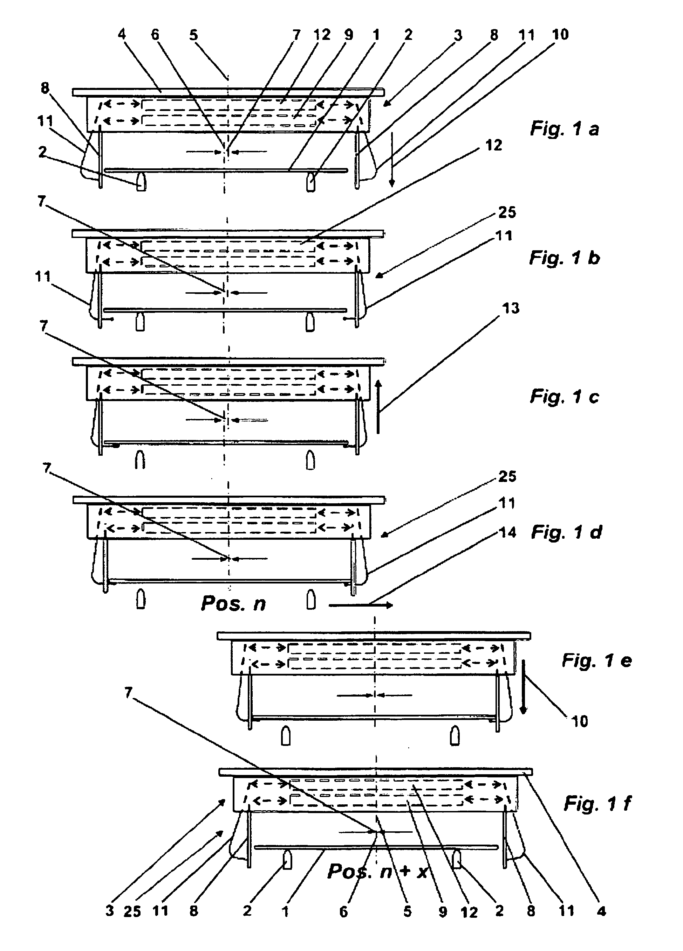

In **Figur 1a** liegt ein Gut 1 auf Ablagen 2 in einer unbestimmten, d. h. toleranzbehafteten Lage. Die Greifvorrichtung 3, die mittels z. B. eines Adapters 4 an einem nicht dargestellten Handhabungsgerät oder einem Roboterarm befestigt ist, ist von diesem über dem Gut 1 in der Anlagenposition n im hier bereits gesenkten Zustand positioniert. Das erfolgte Absenken zeigt symbolisch der Senkpfeil 10. Das Greifvorrichtungszentrum 5 weicht vom Gutzentrum 6 um den Versatz 7 ab. Korrekt soll der Versatz 7 null sein. Zur Korrektur bzw. Aufhebung des Versatzes 7 dienen verlagerbare Richtmittel 8, die von mindestens einem Richtaktor 9 betätig, d. h. geöffnet und geschlossen werden. Dieses Richten könnte in der Situation erfolgen, wie sie die Figur 1a zeigt. Hierzu würden die Richtmittel 8 vom oder von den Richtaktoren 9 in Richtung des Greifvorrichtungszentrums 5 bewegt werden. Dabei verschiebt sich das Gut 1, das lose auf den Ablagen 2 liegt, derart, dass der Versatz 7 null wird. Diese erfindungsgemäße Möglichkeit der Korrektur ist in der Figur 1a jedoch nicht dargestellt. Sie erfolgt bei den in der Figur 1 dargestellten Abläufen erst später.

In den Figuren 1 sind beispielhaft als Ablagen 2 mechanisch tragende Pins dargestellt. Als Ablage 2 können auch anders gestaltete Auflagen dienen, die mindestens einen Teil des Gutes im Randbereich freihalten. So kann als Ablage 2 auch eine Flüssigkeitsoberfläche dienen, auf der das Gut schwimmt. Auch ein Gaspolster, insbesondere ein Luftpolster, ist als Ablage 2 realisierbar. Auch eine Kombination von mechanischen Ablagen 2 und Flüssigkeitsoberflächen oder Luftpolster zur Ablage des Gutes ist realisierbar. Zum Beispiel bei einer elektrolytischen Behandlung können dabei die Ablagen 2 als elektrische Kontakte zur Stromübertragung auf das mindestens einseitig in der Behandlungsflüssigkeit befindliche Gut dienen.

In **Figur 1b** erfolgte ein Unterfahren des Gutes 1 durch die mindestens zwei zuvor ausgefahrenen d. h. vom Gut 1 beabstandeten Aufnahmen 11. Hierzu dient mindestens ein Aufnahmeaktor 12, der oder die sich in der Greifvorrichtung befinden. Alle Aktoren 9, 12 werden von einem zentralen Steuerungssystem der Produktionsanlage zeitgerecht gesteuert. In der Figur 1b erfolgt das Unterfahren der Aufnahmen 11 durch eine Schwenkbewegung um nicht dargestellte Achsen, die sich in der Greifvorrichtung 3 befinden. Die Aufnahmen 11 sind in diesem Beispiel als Bügel ausgeführt, die z. B. aus Metall oder Kunststoff bestehen. Bei Nassprozessen werden vorteilhaft hydrophobe Werkstoffe mindestens an den Oberflächen der Aufnahmen 11 verwendet. Damit wird ein ansonsten mögliches Übertragen von Behandlungsflüssigkeit auf Bereiche des Gutes und/oder auf die Greifvorrichtung vermieden, wenn sie trocken bleiben sollen. Gleiches gilt auch für die Oberflächen der Richtmittel 8 und der Richtanschläge 28, die mit Behandlungsflüssigkeit in Berührung kommen können.

Das Unterfahren der Aufnahmen 11 kann z. B. auch durch eine lineare oder nichtlineare Schubbewegung erfolgen. Der Unterfahrweg wird so groß gewählt, dass auch bei einem maximal möglichen Versatz 7 das Gut 1 von allen Aufnahmen 11 erreicht und aufgenommen werden kann. Das aufgenommene und getragene Gut 1 zeigt die **Figur 1c****.** Der Hubpfeil 13 kennzeichnet diese Bewegung der Greifvorrichtung 3. Das Gut liegt horizontal verschiebbar auf den Aufnahmen 11, wobei die Zentren 5, 6 der Greifvorrichtung 3 und des Gutes 1 um den Versatz 7 nicht übereinstimmen.

Wenn das Gut in oder auf einer Flüssigkeit liegt, kann es vorteilhaft sein, das Ausheben desselben in einer geringfügigen Schräglage durchzuführen z. B. mit 1 mm bis 10 mm Höhenunterschied von zwei gegenüberliegenden Kanten. Dies erleichtert den Abriss der Flüssigkeit, die am Gut anhaftet. Die Schräglage wird an der Greifvorrichtung durch entsprechend unterschiedliche hoch eingestellte Aufnahmen 11 erreicht.

Das Gut 1, das von den Ablagen 2 abgehoben ist, wird mittels der verlagerbaren Richtmittel 8 gerichtet. Hierzu schließen die Richtmittel, d. h. sie bewegen sich symmetrisch in Richtung zum Greifvorrichtungszentrum 5. Dabei wird das Gut 1 auf den Aufnahmen 11 so verschoben, dass der Versatz 7 null wird, wie es die **Figur 1d** zeigt. Zugleich oder nach dieser Korrektur erfolgt der Transport des Gutes 1 zu einer anderen Anlagenposition z. B. Position n + x. Den Transport kennzeichnet der Transportpfeil 14.

Die Zielposition zeigt die **Figur 1e****.** In diese wird das auf den Aufnahmen 11 gerichtet liegende Gut 1 durch Senken der Greifvorrichtung 3 auf den Ablagen 2 sehr präzise abgelegt, weil die Lage der Greifvorrichtung 3 und die Koordinaten, d. h. die Orte der Ablagen 2 im Steuerungssystem bekannt sind. Dabei können die Richtmittel geschlossen oder geöffnet sein. Das abgelegte Gut 1 zeigt die **Figur 1f****.** Der Versatz 7 ist bestimmungsgemäß null. Sichergestellt wird diese Präzision des Ablegens durch die das Gut 1 tragenden Aufnahmen 11. Sie werden durch die Senkbewegung der Greifvorrichtung 3 vom Gut 1 in vertikaler Richtung nach unten abgehoben, wenn das Gut 1 die Ablagen 2 erreicht und die Greifvorrichtung 3 weiter abgesenkt wird. Dabei entstehen keine horizontal wirkenden Kräfte, die das Gut 1 verschieben könnten. Somit bleibt die Richtposition exakt erhalten.

Das Ablegen des Gutes 1 kann auch in einer geringfügig schrägen Lage des Gutes erfolgen. Dies ermöglicht ein sicheres zur Seite Ableiten von Luft, wenn das Gut auf einer Flüssigkeitsoberfläche mit oder ohne zusätzliche Ablagen 2 abgelegt werden soll. Die Schräglage des Gutes an der Greifvorrichtung wird durch entsprechend unterschiedlich tief an dieser eingestellte Aufnahmen 11 erreicht. Vorzugsweise erfolgt in diesem Falle das Absenken mit geschlossenen Richtmitteln 8.

Es besteht schließlich auch die Möglichkeit, das Gut 1 erst nach einem unkorrigierten Ablegen auf den Ablagen 2 in der Zielposition mittels der Richtmittel 8 zu richten. Dies kann vorteilhaft sein, wenn z. B. während eines schellen Transportes oder Ablegens in der Zielposition ein unkontrollierbares Verschieben des Gutes 1 auf den Aufnahmen 11 und/oder auf den Ablagen 2 nicht zu vermeiden ist. Dieses Richten würde dann erst in der Situation entsprechend der Figur 1 f erfolgen.

Die **Figur 1f** zeigt bereits ausgefahrene Aufnahmen 11 und geöffnete Richtmittel 8, wodurch die Greifvorrichtung 3 ohne Gut 1 zur Hubbewegung und zur Transportbewegung bereit ist, um eines weiteres Gut von einer anderen Anlagenposition abzuholen.

Anstelle der in Figur 1 dargestellten beweglichen bzw. schwenkbaren Aufnahmen 11 kann an der Greifvorrichtung 3 auch ein Vakuumgreifer, bevorzugt als Bernoulli-Greifer, angeordnet werden. Dieser ergreift das auf den Ablagen 2 liegende Gut 1 zum Transportieren an dessen Oberseite. Das vom Bernoulli-Greifer gegriffene Gut 1 ist an diesem ebenso seitlich verschiebbar, wie das auf den Aufnahmen 11 liegende Gut, das in Figur 1 beschrieben wurde. Das seitliche Verschieben bzw. Korrigieren der Lage des vom Bernoulli-Greifer gegriffenen Gut 1 mittels der Richtmittel 8 entspricht einem gezielten Wegschwimmen desselben.

Auch bruchempfindliches Gut, das vom Bernoulli-Greifer gegriffen wurde, eignet sich zum seitlichen Verschieben. Bei einem flachen Gut oder Substrat besteht die kritische Bruchempfindlichkeit nur bei vertikal auf dieses einwirkende Kräfte. Weil die erfindungsgemäßen Richtmittel 8 nur Schubkräfte in horizontaler Richtung auf das flache Gut an dessen Kanten einleiten, besteht beim Richten keine besondere Bruchgefahr, auch wenn dieses schwimmend am Bernoulli-Greifer haftet. Somit gilt die Beschreibung der Greifvorrichtung anhand der Figuren 1 bis 5 gleichermaßen für das Ergreifen, Tragen und Richten von Gut mittels der Aufnahmen 11 oder mittels eines Bernoulli-Greifers oder eines anderen Vakuumgreifers.

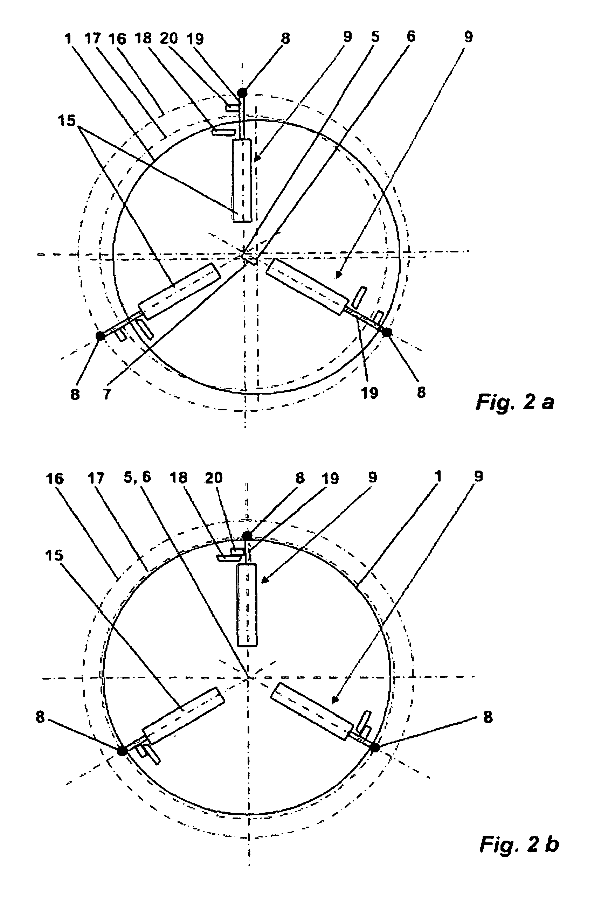

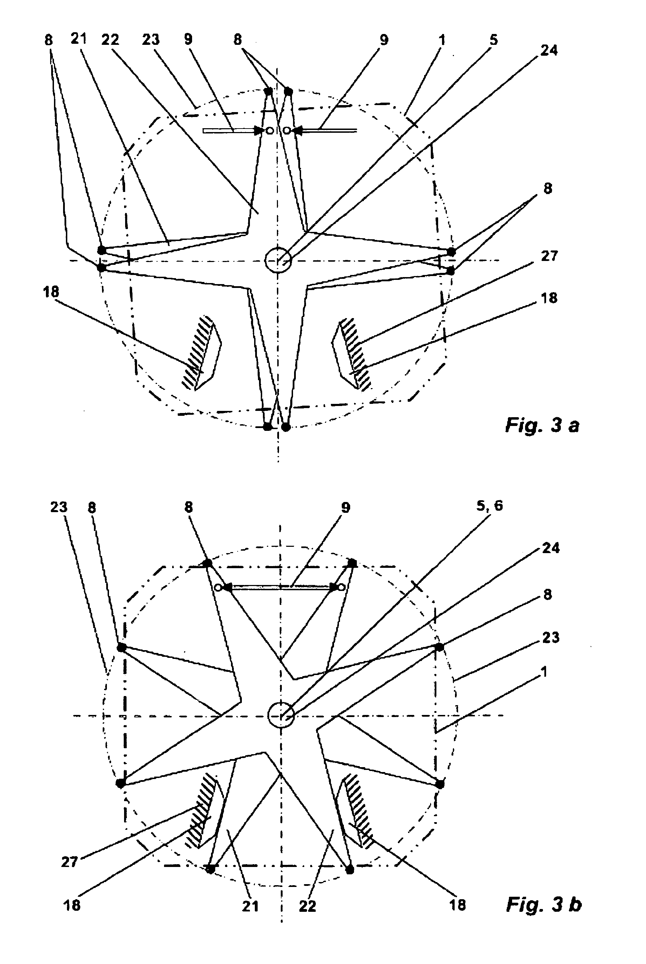

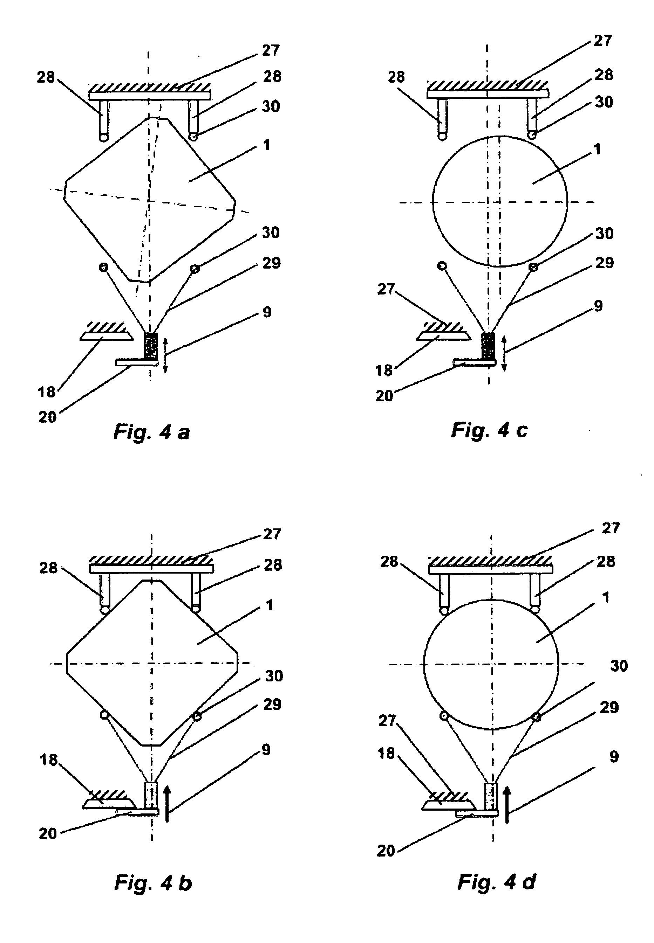

Die Figuren 2a und 2b zeigen nur noch die Richtmittel, ihre Antriebe und das Gut 1. Aus Gründen der Übersichtlichkeit sind weitere Details der Greifvorrichtung 3 wie z. B. die Aufnahmen 11 oder ein Bernoulli-Greifer nicht dargestellt. Gleiches gilt auch für die Figuren 3a und 3b sowie für die Figuren 4a bis 4d.

In **Figur 2a** sind die Richtmittel 8 geöffnet. Sie befinden sich über dem abgelegten Gut 1, das hier als Beispiel eine runde Scheibe, z. B. einen Wafer zeigt. Güter mit anderen Formen bzw. Vielecke sind in gleicher Weise mit einer dafür entsprechenden Anzahl von Richtmitteln 8 handhabbar, so sind bei dieser dargestellten Ausführung der Greifvorrichtung z. B. für ein quadratisches Gut mindestens drei Richtmittel erforderlich. Das Gut 1 befindet sich in einer unbestimmten Lage zur Greifvorrichtung 3 und damit zu den Richtmitteln 8. Die Richtmittel 8 werden hier linear mittels z. B. Pneumatikzylinder 15 und Kolbenstangen 19 als Richtaktoren 9 bewegt. Besonders bei einem schweren zu handhabenden Gut sind auch Hydraulikzylinder geeignet, sowie elektrische Linearantriebe oder Schwenkantriebe aller Art.

Im geöffneten Zustand befinden sich die Richtmittel 8 auf einem großen Teilkreis 16. Der Radius dieses Teilkreises 16 ist größer, als der maximal vorkommende Versatz 7 des Gutzentrums 6 vom Greifvorrichtungszentrum 5. Das Richten vor, während oder nach dem Transport zur Zielposition erfolgt durch das Verlagern bzw. Schließen der Richtmittel 8. Dabei nehmen die mindestens zwei, hier die bevorzugt symmetrisch angeordneten drei Richtmittel 8 in Figur 2b eine Lage ein, die der kleine Teilkreis 17 beschreibt. Das Zentrum dieses Teilkreises 17 ist an der Greifvorrichtung unverrückbar und damit dem Steuerungssystem der Anlage bekannt. Somit ist auch die Lage des gerichteten Gutes 1 im Steuerungssystem bekannt. Die Richtmittel 8 können allgemein auch asymmetrisch an der Greifvorrichtung angeordnet sein. Ihre Lage muss dem Steuerungssystem der Anlage mindestens einmal mitgeteilt worden sein.

Damit ein bruchempfindliches Gut durch zu weit erfolgte Schließbewegungen der Richtmittel nicht beschädigt werden kann, können an der Greifvorrichtung 3 Anschläge 18 und an den Kolbenstangen 19 Nocken 20 angeordnet werden. Die Schließbewegungen der Richtmittel 8 werden dann durch die Anschläge 18 und die dagegen fahrenden Nocken 20 sehr genau begrenzt. Die Anschläge 18 und Nocken 20 werden so eingestellt, dass das Gut gerichtet aber nicht eingeklemmt wird. Damit wird eine Beschädigung des Gutes 1 sicher vermieden. Die Bewegungen der in diesem Beispiel drei Richtmittel 8 kann natürlich auch von einem einzigen Richtaktor abgeleitet werden. Hierzu dienen bekannte Mittel der Antriebstechnik wie z. B. Hebel, Zahnräder oder Zahnriemen.

Die **Figur 2b** zeigt das gerichtete Gut 1. Hierbei befinden sich die Nocken 20 an den Anschlägen 18. Bei Verwendung eines einzigen Richtaktors kann auch ein Anschlag ausreichend sein. Die als Beispiel dargestellten Pneumatikzylinder verlagern die Richtmittel 8 linear. Realisierbar ist eine Greifvorrichtung auch mit anderen Bewegungen der Richtmittel, z. B. drehende, schwenkende oder nichtlineare Bewegungen.

Eine sehr vorteilhafte Ausführung der Erfindung mit einer drehenden Verlagerung der Richtmittel 8 durch nur einen Richtaktor 9 zeigen die **Figuren 3a und 3b****.** Dieses Beispiel der Erfindung eignet sich grundsätzlich für Gut als beliebige Vielecke. Dargestellt ist ein quadratisches Gut in Form einer Solarzelle. In der **Figur 3a** sind die Richtmittel 8 geöffnet. Sie befinden sich auf zwei Richtmittelträgern, nämlich Richtmittelträger 21 und Richtmittelträger 22. Diese Richtmittelträger können z. B. als Scheiben oder Speichenräder ausgebildet sein. In der Figur 3 sind sie sternförmig ausgeführt. Der Richtaktor 9 ist in seiner Wirkungsweise symbolisch durch die Pfeile und ihre Wirkungsrichtung dargestellt. Die Richtmittelträger 21 und 22 sind z. B. im Zentrum der Greifvorrichtung auf einer Achse 24 begrenzt drehbar gelagert. Der Richtaktor 9 hat die Richtmittelträger 21 und 22 und damit die Richtmittel 8 in Figur 3 a geöffnet, d. h. vom Gut 1 entfernt. Dieses befindet sich in einer unbestimmten Lage zum Zentrum 5 der Greifvorrichtung 3.

Durch gegenläufiges Drehen der Richtmittelträger 21 und 22 mittels des Richtaktors 9 in Schließrichtung bewegen sich die Richtmittel 8 gegenläufig auf dem Teilkreis 23 in Richtung zum Rand des quadratischen Gutes. Die Endpositionen der Richtmittelträger 21 und 22 infolge der Richtbewegungen zeigt die **Figur 3b****.** Insbesondere bei einem bruchempfindlichen Gut können diese Endpunkte der Richtmittel wieder durch Anschläge 18 begrenzt werden. Die beiden Richtmittelträger 21 und 22 bewegen sich bis zu diesen Anschlägen 18. Sie sind so eingestellt, dass das Gut 1 vollständig ausgerichtet ist, ohne dabei jedoch eine Klemmung am Gut durch die Richtmittel zu verursachen.

Die Lagen der Anschläge 18 sind von den Abmessungen des Gutes abhängig, d. h. eine feste Einstellung der Anschläge erlaubt nur eine bestimmte Größe von Gut zu handhaben. Das Richten kann auch bei dieser Ausführung der Greifvorrichtung 3 vor, während oder nach dem Transport des Gutes von einer Anlagenposition zur nächsten erfolgen, so wie es oben beschrieben wurde. Die Bewegungen der nicht dargestellten Aufnahmen 11 erfolgen auch bei den Ausführungen der Greifvorrichtung gemäß der Figuren 2 und 3 ebenso, wie es am Beispiel der Figur 1 beschrieben wurde. Gleiches gilt für das Ergreifen des Gutes mittels eines Vakuumgreifers.

In der Ausführung der Erfindung gemäß der Figuren 3a und 3b betätigt sehr vorteilhaft nur ein Richtaktor 9 gleichzeitig gegenläufig beide Richtmittelträger 21, 22 durch Expansion und Kompression. Dieser beispielhafte schwimmende Antrieb erfordert für den Richtaktor 9 keinen weiteren Fixpunkt an der Greifvorrichtung. Mindestens ein Anschlag 18 bestimmt den Weg der Richtmittel 8 und damit die Richtlage des Gutes 1. Auch der Aufnahmeaktor 12 kann für seine beiden Bewegungsrichtungen zum Antrieb der Aufnahmen 11 schwimmend angeordnet werden.

Nicht reversierende, d. h. einseitig wirkende Aktoren 9, 12 sind ebenfalls in der Greifvorrichtung verwendbar. In diesem Falle wird die Rückstellkraft jeweils von einer Feder aufgebracht, die bei der einseitigen Aktorbewegung gespannt wurde.

Die **Figuren 4** zeigen Ausführungen der Greifvorrichtung mit einem besonders geringen technischen Aufwand für die Richtmittel. Das Richten des Gutes 1 erfolgt hier durch nur ein einziges zweischenkliges Richtmittel 29, das von einem Richtaktor 9 betätigt wird. Dieses zweischenklige Richtmittel 29 verlagert das Gut 1 gegen zwei statische Richtanschläge 28, die an einem Festpunkt 27 der Greifvorrichtung unverrückbar angeordnet sind. Die statischen Richtanschläge 28 sind in diesem Beispiel ähnlich voneinander beabstandet angeordnet, wie die Angriffspunkte für das Gut auf dem zweischenkligen Richtmittel 29. Damit ergeben sich beim Richten vier Angriffspunkte der Richtmittel 29 und der Richtanschläge 28. Diese Angriffspunkte gleiten beim Richten an den Kanten des Gutes entlang. Daher ist es vorteilhaft, die Angriffspunkte als gesonderte Gleiter 30 an dem zweischenkligen Richtmittel 29 und an den Richtanschlägen 28 auszuführen. Die Gleiter 30 bestehen aus einem verschleißfestem Werkstoff mit einem sehr kleinem Reibwert für die Werkstoffpaarung Gut / Gleiter. Die Gleiter 30 können auch als rotierende Körper z. B. als Walzen ausgeführt und an dem zweischenkligen Richtmittel 29 und an den Richtanschlägen 28 befestigt sein.

Die geometrischen Maße der statischen Richtanschläge 28 sowie ihre Lage an der Greifvorrichtung 3 sind unveränderlich. Bekannt und gleichbleibend sind auch die Form und die Größe des zu richtenden Gutes. Dies erlaubt wieder die dafür erforderliche Begrenzung des Weges, den das bewegliche zweischenklige Richtmittel 29 beim Richten maximal zurücklegt. Dafür ist der an einem Festpunkt 27 der Greifvorrichtung befestigte Anschlag 18 eingestellt. Gegen diesen Anschlag 18 bewegt der Richtaktor 9 das zweischenklige Richtmittel 29 beim Richtvorgang. Der Anschlag ist wieder so eingestellt, dass das Gut weder geklemmt noch beschädigt werden kann. Die Lage des derart gegen die statischen Richtanschläge 28 ausgerichteten Gutes ist an der Greifvorrichtung und damit im Steuerungssystem der Produktionsanlage bekannt. Somit kann ein in der Lage unbestimmt aufgenommenes oder gegriffenes Gut in der Zielposition mittels des Steuerungssystems exakt abgelegt werden.

Die Verwendung eines einzigen beweglichen zweischenkligen Richtmittels 29 eignet sich u. a. für quadratisches Gut wie z. B. Solarzellen oder für rundes Gut wie z. B. Wafer. Die **Figur 4a** zeigt eine Solarzelle, die in einer unbestimmten Lage in einer Abholposition liegt. Die Greifvorrichtung ist mit geöffnetem zweischenkligen Richtmittel 29 vom Handhabungsgerät oder Roboterarm der Produktionsanlage über dem Gut positioniert. Durch Schließen des Richtmittels bis zum Anschlag 18 erreicht das Gut die vorbestimmte ausgerichtete Lage, sowie es die **Figur 4b** zeigt. Die **Figur 4c** zeigt ein rundes Gut, das aus einer unbestimmten Lage abgeholt werden soll. Zur zielgenauen Ablage wird es von dem einen zweischenkligen Richtmittel 29 gerichtet sowie es die **Figur 4d** zeigt.

Vorstehend wurde die Erfindung besonders zum Handhaben von Gütern beschrieben, die gleichbleibende Abmessungen aufweisen. Sie eignet sich jedoch auch sehr vorteilhaft zum Greifen, Transportieren und Richten von Gütern mit verschieden großen Nennmaßen. Hierfür werden an der Greifvorrichtung entsprechend manuell verstellbare Anschläge 18 verwendet, wenn z. B. der Wechsel der Abmessungen des zu produzierenden Gutes in größeren Zeitabständen erfolgt. Bei häufigerem Wechsel kann die Verstellung der Anschläge 18 vom Steuerungssystem gesteuert automatisch erfolgen. Die hierfür erforderlichen mechanischen und elektromechanischen Konstruktionselemente sowie die Software sind Stand der Technik.

An Stelle der verstellbaren Anschläge 18 können für den oder die Antrieb(e) der Richtmittelträger, d. h. insbesondere für die Richtaktoren 9 auch präzise Positionierantriebe verwendet werden. Sie bewegen die Richtmittel 8 in Abhängigkeit von den Abmessungen des zu greifenden Gutes soweit, dass das individuelle Gut gerichtet, und besonders bei bruchempfindlichem Gut nicht geklemmt wird. Die Steuerung der Antriebe erfolgt ebenfalls durch das übergeordnete Steuerungssystem. Dieses hat die zum individuellen Steuern erforderlichen Daten gespeichert, d. h. die Endpositionen der Richtmittelträger 19, 21, 22 für die jeweils momentan zu handhabenden Güter.

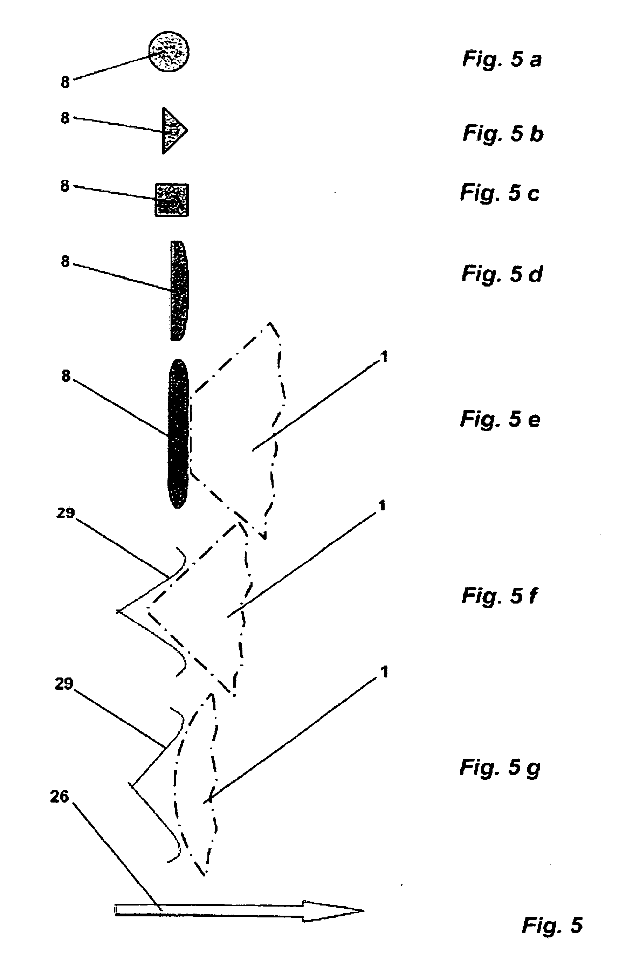

Die **Figur 5** zeigt Beispiele von Querschnitten der Richtmittel 8 oder der Richtanschläge 28, so wie sie für die Ausführungen der Erfindung anwendbar sind. Zum Schutz des Gutes gegen eine Beschädigung beim Richten kann mindestens die Berührungsfläche oder die Berührungslinie der Richtmittel 8 oder der Richtanschläge 28 zur Kante des Gutes aus einem elastischen und/oder hydrophoben Werkstoff bestehen.

Der Querschnitt in **Figur 5a** ist technisch einfach und daher zu bevorzugen, nicht zuletzt, weil die Berührungsfläche bzw. Berührungslinie zur Kante des Gutes klein ist. Dies vermeidet ein oft unzulässiges Übertragen von Behandlungsflüssigkeit vom Gut zu den Richtmitteln und umgekehrt. Der Querschnitt in **Figur 5b** hat eine noch kleinere Berührungslinie zur Kante des zu richtenden Gutes. Der Querschnitt in **Figur 5c** zeigt ebenfalls eine technisch einfache und stabile Ausführung, jedoch mit einer größeren Berührungsfläche.

Die Querschnitte in den **Figur 5d bis 5g** eignen sich als Richtmittel auch besonders für den Anschlag an einer spitzen oder eingezogenen Ecke des Gutes. Die Figuren **5d und 5e** eignen sich zusätzlich auch zum Verschieben des Gutes an einer Ecke oder einer eingezogenen Ecke, um diese sicher zu treffen. Das Richten über Eck ist dann vorteilhaft, wenn die Anzahl der Richtmittel 8, die für eine jeweilige Geometrie des Gutes erforderlich ist, klein sein soll.

Besonders zur Reduzierung der Anzahl der erforderlichen Richtmittel an einer Greifvorrichtung eignen sich die Querschnitte der zweischenkligen Richtmittel 29, die in den **Figur 5f und 5g** dargestellt sind. Diese Richtmittel 29 greifen an zwei Seiten des z. B. quadratischen oder runden Gutes an und richten es zugleich in zwei Richtungen aus. Diese zweischenklige Ausführung eignet sich natürlich auch zum Angriff an eine Längsseite eines Gutes.

Ähnlich wie in der Figur 5f und 5g dargestellt, können die zweischenklige Richtmittel 29 an die Erfordernisse z. B. eines vieleckigen Gutes angepasst werden.

Die Figur 5e zeigt strichpunktiert ein Gut 1 als Solarzelle mit eingezogener Ecke. Die Figur 5f zeigt strichpunktiert die Ecke eines quadratischen oder rechteckigen Gutes 1 und die Figur 5g zeigt ein rundes Gut, die von einem zweischenkligen Richtmittel 29 gerichtet, d. h. bewegt werden.

Der Richtpfeil 26 zeigt in den Figuren 5 die Bewegungsrichtung der Richtmittel 8 beim Richten des Gutes 1.

Bruchempfindliches Gut wird mittels der erfindungsgemäßen Greifvorrichtungen sehr schonend gehandhabt. Jedoch kann es bereits während des Prozesses auf den Ablagen der Prozesskammern zu Beschädigungen oder zum vollständigen Bruch des Gutes kommen. Um dies in einer Produktionsanlage frühzeitig zu erkennen, kann die Greifvorrichtung 3 zusätzlich mit mindestens einem Sensor ausgerüstet werden. Dieser prüft das Gut auf Unversehrtheit. Das Prüfen bzw. detektieren kann zeitlich parallel zur beschriebenen Handhabung des Gutes erfolgen. Die Art des Sensors wird an die Eigenschaften des zu prüfenden Gutes angepasst. Entsprechend sind z. B. optische, induktive, kapazitive oder Ultraschallsensoren geeignet. Zum Detektieren von siliziumbehaftetem Gut können u. a. vorteilhaft Ultraschallsensoren verwendet werden.

### Bezugszeichenliste

- 1: Gut, Substrat
- 2: Ablage, Flüssigkeitsoberfläche, Luftpolster
- 3: Greifvorrichtung
- 4: Adapter
- 5: Greifvorrichtungszentrum
- 6: Gutzentrum
- 7: Versatz
- 8: Richtmittel
- 9: Richtaktor
- 10: Senkpfeil
- 11: Aufnahmen
- 12: Aufnahmeaktor
- 13: Hubpfeil
- 14: Transportpfeil
- 15: Pneumatikzylinder, Linearantrieb
- 16: großer Teilkreis
- 17: kleiner Teilkreis
- 18: Anschlag
- 19: Kolbenstange, Richtmittelträger
- 20: Nocke
- 21: Richtmittelträger
- 22: Richtmittelträger, gegenläufig
- 23: Teilkreis
- 24: Achse
- 25: Greifmittel
- 26: Richtpfeil
- 27: Festpunkt an der Greifvorrichtung
- 28: Richtanschlag
- 29: zweischenkliges Richtmittel
- 30: Gleiter

## Patentansprüche

1. Vorrichtung zum Handhaben von Gut (1), insbesondere zum Transport in bevorzugt horizontaler oder geneigter Lage von bruchempfindlichen Substraten als Wafer oder Solarzellen in gesteuerten Produktionsanlagen von einer Ablagestelle eines Nass- oder Trockenprozess zur nächsten mittels einer Greifvorrichtung (3), die sich an einem Handhabungsgerät oder an einem Roboterarm befindet, mit mindestens einem Greifmittel (25) zum Aufnehmen oder Ergreifen des Gutes (1) und mindestens drei verlagerbaren Richtmitteln (8) zur horizontalen Verschiebung des Gutes (1) sowie einem Richtaktor (9) zum gemeinsamen Öffnen und Schließen der Richtmittel, **dadurch gekennzeichnet, dass** die Vorrichtung ferner zwei Richtmittelträger (21, 22) umfasst, auf denen die Richtmittel (8) in zwei Gruppen symmetrisch angeordnet sind, wobei die Richtmittelträger im Zentrum (5) der Greifvorrichtung (3) um eine Achse (24) gegeneinander drehbar gelagert und von dem Richtaktor (9) zum Öffnen und Schließen der Richtmittel (8) auf einer Kreisbahn oder einem Teilkreis (23) gegenläufig verlagerbar sind.

2. Vorrichtung nach Anspruch 1, welche mindestens zwei Greifmittel (25) zum vertikalen Aufnehmen des Gutes (1) umfasst, wobei die Greifmittel als Aufnahmen (11) ausgestaltet sind.

3. Vorrichtung nach Anspruch 1, wobei das mindestens eine Greifmittel (25) als Vakuumgreifer oder Bernoulli-Greifer ausgestaltet ist.

4. Vorrichtung nach einem der vorhergehenden Ansprüche, wobei der Richtaktor (9) als elektrischer, pneumatischer oder hydraulischer Antrieb ausgestaltet ist.

5. Vorrichtung nach einem der vorhergehenden Ansprüche, wobei der Aktor (9) schwimmend an den Konstruktionselementen der Greifvorrichtung (3) angeordnet ist.

6. Vorrichtung nach einem der vorhergehenden Ansprüche, wobei der Aktor (9) einseitig wirkend und durch Federkraft rückstellbar ausgestaltet ist.

7. Verfahren zum Handhaben von Gut (1), insbesondere zum Transport in bevorzugt horizontaler oder geneigter Lage von bruchempfindlichen Substraten als Wafer oder Solarzellen in gesteuerten Produktionsanlagen von einer Ablagestelle eines Nass- oder Trockenprozess zur nächsten mittels einer Greifvorrichtung (3), die sich an einem Handhabungsgerät oder an einem Roboterarm befindet, unter Verwendung der Vorrichtung gemäß Definition nach einem der Ansprüche 1 bis 6, wobei das Verfahren die folgenden Verfahrensschritte umfasst:
a) Positionieren der Greifvorrichtung (3) über dem aufzunehmenden Gut (1);
b) Absenken der Greifvorrichtung (3) mit dem mindestens einen Greifmittel (25) und geöffneten Richtmitteln (8) bis zu einer Tiefe, die ein Aufnehmen oder Ergreifen erlaubt, ohne das Gut dabei zu berühren;
c) Aufnehmen oder Ergreifen des Gutes (1);
d) Ausheben der Greifvorrichtung (3) mindestens soweit, dass das Gut von der Ablagestelle abgenommen ist;
e) Transport des Gutes zur nächsten Ablagestelle; und
f) Absenken der Greifvorrichtung (3) und Ablegen des Gutes auf der nächsten Ablagestelle; wobei
g) zwischen den Verfahrensschritten b) und c), oder c) und d), oder d) und e), oder e) und f), oder während des Verfahrensschrittes e), oder nach dem verfahrensschritt f) ein horizontales Richten des Gutes (1) durch Verlagern der an der Greifvorrichtung (3) angeordneten Richtmittel (8) in eine vorbestimmte Richtlage erfolgt, die in einem festen räumlichen Bezug zur Greifvorrichtung steht.

8. Verfahren nach Anspruch 7, wobei die Richtmittel (8) beim Richten das Gut (1) verschieben, ohne dass es dabei zu einer Klemmung desselben kommt.

## Claims

1. Apparatus for the handling of good (1), in particular for the transport of fragile substrates such as wafers or solar cells in a preferably horizontal or inclined position in controlled production plants from one to a subsequent storage location of a wet or dry process by means of a gripper device (3) which is arranged at a manipulation device or at a robotic arm, with at least one gripping means (25) for picking up or gripping of the good (1), and with at least three displaceable orienting means (8) for the horizontal displacement of the good (1), as well as with an orienting actuator (9) for the common opening and closing of the orienting means, **characterized in that** the apparatus further comprises two orienting means carriers (21, 22) onto which the orienting means (8) are symmetrically arranged in two groups, wherein the orienting means carriers are rotatable in the center (5) of the gripper device (3) relative to each other around an axis (24), and wherein they are, for opening and closing of the orienting means (8), displaceable in opposite directions along a circular path or a dividing circle (23) by means of the orienting actuator (9).

2. Apparatus according to claim 1, comprising at least two gripping means (25) for the vertical picking up of the good (1), wherein the gripping means are designed as holding fixtures (11).

3. Apparatus according to claim 1, wherein the at least one gripping means (25) is designed as a vacuum gripper or as a Bernoulli-gripper.

4. Apparatus according to any of the preceding claims, wherein the orienting actuator (9) is designed as an electrical, pneumatic or hydraulic drive.

5. Apparatus according to any of the preceding claims, wherein the actuator (9) is floatingly arranged at the construction elements of the gripper device (3).

6. Apparatus according to any of the preceding claims, wherein the actuator (9) is designed to be unilaterally acting and to be resettable by spring force.

7. Method for the handling of good (1), in particular for the transport of fragile substrates such as wafers or solar cells in a preferably horizontal or inclined position in controlled production plants from one to a subsequent storage location of a wet or dry process by means of a gripper device (3) which is arranged at a manipulation device or at a robotic arm, by use of the apparatus as defined in any of claims 1 to 6, wherein the method comprises the following process steps:
(a) positioning of the gripper device (3) above the good (1) to be picked up;
(b) lowering of the gripper device (3) with the least one gripping means (25) and the opened orienting means (8) down to a depth which allows for picking up or gripping without touching the good (1);
(c) picking up or gripping of the good (1);
(d) lifting up of the gripper device (3) at least so far that the good is removed from the storage location;
(e) transporting of the good to the subsequent storage location; and
(f) lowering of the gripper device (3) and depositing of the good onto the subsequent storage location; wherein
(g) a horizontal orientation of the good (1) takes place between process steps (b) and (c), or (c) and (d), or (d) and (e), or (e) and (f), or during process step (e), or after process step (f), by displacing the orienting means (8) being are arranged at the gripper device (3) into a predetermined orienting position which is in a fixed spatial relation to the gripper device (3).

8. Method according to claim 7, wherein the good (1) is displated upon orienting by the orienting means (8), without a clamping of the same taking place.

## Revendications

1. Dispositif pour la manipulation de bien (1), en particulier pour le transport de substrats fragiles comme des plaques de silice ou des cellules photovoltaïques dans une position préférentiellement horizontale ou inclinée dans des unités de production à commande d'une station de déchargement à la prochaine au cours d'un procédé chimique humide ou sec au moyen d'un dispositif de préhension (3) qui se situe au niveau d'un appareil manuel ou d'un bras robotique, avec au moins un outil de préhension (25) pour fixer ou agripper le bien (1) et au moins trois outils de positionnement déplaçables (8) pour le déplacement horizontal du bien (1) ainsi que un agent de positionnement (9) pour l'ouverture et la fermeture commune des outils de positionnement, **caractérisé en ce que** le dispositif comprend de plus deux porteurs d'outil de positionnement (21, 22) sur lesquels les outils de positionnement (8) sont ordonnés symétriquement en deux groupes, les porteurs des outils de positionnement sont montés de manière à être pivotants les uns par rapport aux autres autour d'un axe (24) au centre (5) du dispositif de préhension (3) et ils sont déplaçables en direction opposée sur une piste circulaire ou une partie circulaire (23) par l'agent de positionnement (9) pour ouvrir et fermer les outils de positionnement (8).

2. Dispositif selon la revendication 1 qui comprend au moins deux outils de préhension (25) pour la prise verticale du bien (1), les outils de préhension étant conçus comme des fixations (11).

3. Dispositif selon la revendication 1 dans lequel le, au moins un, outil de préhension (25) est conçu comme un grappin à vide ou grappin de Bernoulli.

4. Dispositif selon une des revendications précédentes dans lequel l'agent de positionnement (9) est conçu comme un propulseur électrique, pneumatique ou hydraulique.

5. Dispositif selon une des revendications précédentes dans lequel l'agent (9) est disposé, flottant, adjacent aux éléments de construction du dispositif de préhension (3).

6. Dispositif selon une des revendications précédentes dans lequel l'agent (9) est conçu pour n'agir que d'un coté et pour revenir à sa position initiale par un mécanisme à ressort.

7. Procédé pour la manipulation de bien (1), en particulier pour le transport de substrats fragiles comme des plaques de silice ou des cellules photovoltaïques dans une position préférentiellement horizontale ou inclinée dans des unités de production à commande d'une station de déchargement à la prochaine au cours d'un procédé chimique humide ou sec au moyen d'un dispositif de préhension (3) qui se situe au niveau d'un appareil manuel ou d'un bras robotique, en utilisant le dispositif selon la définition d'une des revendications 1 à 6 dans lequel le procédé comprend les étapes suivantes :
a) Mise en position du dispositif de préhension (3) au dessus du bien (1) à prendre;
b) Descente du dispositif de préhension (3) avec le, au moins un, outil de préhension (25) et les outils de positionnement (8) ouverts jusqu'à une profondeur qui permet la fixation ou la prise sans toucher le bien;
c) Fixation ou prise du bien (1);
d) Montée du dispositif de préhension (3) au moins aussi haut que le bien est ôté de la station de déchargement;
e) Transport du bien jusqu'à la prochaine station de déchargement; et
f) Descente du dispositif de préhension (3) et dépôt du bien sur la prochaine station de déchargement; dans lesquelles
g) un positionnement horizontal du bien (1) se produit entre les étapes du procédé b) et c), ou c) et d), ou d) et e), ou e) et f), ou pendant l'étape du procédé e), ou après l'étape du procédé f)par le déplacement des outils de positionnement (8) localisés au niveau du dispositif de préhension (3) dans une position prédéterminée qui est spatialement fixée par rapport au dispositif de préhension.

8. Procédé selon la revendication 7 dans lequel les outils de positionnement (8) déplacent le bien (1) lors du positionnement sans qu'un blocage de celui-ci se produise.
